(19) **Europäisches Patentamt / European Patent Office / Office européen des brevets**

(11) **EP 3 273 494 B1**

(12) **EUROPEAN PATENT SPECIFICATION**

(45) Date of publication and mention of the grant of the patent:
**14.08.2019 Bulletin 2019/33**

(51) Int Cl.:
*H01L 35/14* (2006.01)     *H01L 35/34* (2006.01)
*C22C 13/00* (2006.01)     *B22F 3/16* (2006.01)
*B22F 9/04* (2006.01)

(21) Application number: **15885399.4**

(22) Date of filing: **16.03.2015**

(86) International application number:
**PCT/JP2015/057711**

(87) International publication number:
**WO 2016/147301 (22.09.2016 Gazette 2016/38)**

(54) **METHOD FOR PRODUCING THERMOELECTRIC MATERIAL**

VERFAHREN ZUR HERSTELLUNG VON THERMOELEKTRISCHEM MATERIAL

PROCÉDÉ DE FABRICATION DU MATÉRIAU THERMOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**24.01.2018 Bulletin 2018/04**

(73) Proprietor: **Hakusan, Inc.**
**Ishikawa 920-8203 (JP)**

(72) Inventors:
• **NISHIZAWA, Shigeru**
  **Saitama 3570038 (JP)**
• **TSURUMI, Shigeyuki**
  **Ishikawa 9200022 (JP)**
• **SATO, Hidetaka**
  **Tokyo 108-0023 (JP)**

(74) Representative: **Green, Mark Charles**
**Urquhart-Dykes & Lord LLP**
**Euston House**
**24 Eversholt Street**
**London NW1 1AD (GB)**

(56) References cited:
EP-A1- 2 447 233     EP-A1- 2 548 845
JP-A- H0 832 123     JP-A- 2008 108 876
JP-A- 2008 108 876     JP-A- 2009 188 368
JP-A- 2010 078 378     JP-A- 2014 192 468
JP-A- 2014 501 036

**Description**

FIELD OF THE INVENTION

The present invention relates to a manufacturing method of a thermoelectric material, and to a manufacturing method of a thermoelectric converter using the thermoelectric material.

BACKGROUND ART

The thermoelectric elements or the thermoelectric converters for converting heat into electricity due to the difference in temperature are well known (for example, NON-PATENT DOCUMENTs 1-4 and PATENT DOCUMENT 1). These thermoelectric elements are configured by electrically connecting in serial two kinds of conductive thermoelectric material pairs of p-type and n-type having thermoelectric properties, and by thermally arranging them in parallel. By applying difference of temperature between both sides of such thermoelectric elements, an electromotive force will occur between both terminals of the thermoelectric elements (Seebeck Effect).

In the known thermoelectric elements, a thermoelectric material such as a bismuth tellurium alloy, a lead/tellurium alloy or a silicon germanium alloy has been used. These thermoelectric materials have the most suitable using ranges in temperature, namely, a temperature range from the room temperature to 250 °C is used as for the bismuth tellurium alloy, a temperature range from 250 °C to 550 °C is used as for the lead/ tellurium alloy, and a temperature range equal to or higher than 550 °C is used as for the silicon germanium alloy.

Furthermore, JP 2014192468 A discloses a thermoelectric material containing magnesium silicon tin alloy. EP 2 447 233 A1 relates to a thermoelectric material based on tin oxide and a method of making a porous thermoelectric material.

In general, the thermoelectric performance of the thermoelectric material is evaluated by a thermoelectric performance index or a thermoelectric figure of merit Z. This figure of merit Z is defined as follows using a Seebeck coefficient S, an electrical resistivity $\rho$ and a thermal conductivity $\kappa$ of the material:

$$Z = S^2/\rho\kappa.$$

That is, the figure of merit Z is high in case that the Seebeck coefficient S is high, the electrical resistivity $\rho$ is small, and/or the thermal conductivity $\kappa$ is low. The dimension of the figure of merit Z is equal to that of an inverse number of the temperature $1/\kappa$.

A coefficient ZT obtained by multiplying a temperature at the time of the measurement with the figure of merit Z becomes dimensionless. This coefficient ZT is called as a dimensionless figure of merit, and used for an evaluation of the thermoelectric performance of thermoelectric material. In case of ZT > 1, the thermoelectric material has practical utility, and, in case of ZT > 3, the thermoelectric material is profitable for the thermoelectric generation.

Although fifty years has been passed from the discovery of the bismuth tellurium alloy, since there is no better thermoelectric material having a higher figure of merit Z than that of the bismuth tellurium alloy, this alloy is still currently used as the thermoelectric material in the temperature range from the room temperature to 250 °C. However, the maximum value of the coefficient ZT of this material is still around 1.3.

NON-PATENT DOCUMENT 1
Kinichi Uemura, Isao Nishida, "Thermoelectric Semiconductor And The Application", Nikkan Kogyo Newspaper Company, 1988
NON-PATENT DOCUMENT 2
Kakuei Matsubara, "About Thermoelectric Conversion", J.Plasma Fusion Res.No.12 p818-824 (2011)
NON-PATENT DOCUMENT 3
Ryo Sakata edition, "Thermoelectric Conversion Basics And Application", Shoukabou, 2005 NON-PATENT DOCUMENT 4
Wei Liu et al, "Convergence Of Conduction Bands As A Means Of Enhancing Thermoelectric Performance Of n-Type Mg2Si1-xSnx Solid Solutions", Physical Review Letters 108 166601 (2012)

PATENT DOCUMENT 1 Japanese Patent No. 5079559

SUMMARY OF THE INVENTION

PROBLEM TO BE SOLVED BY THE INVENTION

The thermal conductivity of the conventional thermoelectric material was in general 5 W/mK or more as for the smelted material and 1 W/mK or more as for the sintered material. As aforementioned, one way for increasing the figure of merit Z is to make the thermal conductivity $\kappa$ small. If the thermal conductivity $\kappa$ is small, since better thermal insulation effect is obtained, it is possible to thin the thermoelectric element. However, because the thermal conductivity $\kappa$ of the conventional thermoelectric material was 1 W/mK or more as above-mentioned, it was extremely difficult to lower this value according to the conventional manufacturing method.

As aforementioned, the bismuth tellurium alloy is still currently used as the thermoelectric material in the temperature range from the room temperature to 250 °C because, in this temperature range, the Seebeck coefficient S of this alloy is higher than that of other materials, the electrical resistivity $\rho$ is smaller than that of other materials, and the thermal conductivity $\kappa$ is lower than that of other materials. Thus, the figure of merit Z is higher than that of the other materials. However, both bismuth and tellurium are heavy metals with toxic and rare for the resources. Particularly, tellurium is produced only a few hundred tons per year all over the world, and therefore it is difficult to widely use this tellurium as the thermoelectric material. Under these circumstances, a material with no problem for the resources and capable of providing performance similar to that of the bismuth tellurium alloy is demanded.

The main substance of the bismuth tellurium alloy is a compound $Bi_2Te_3$ and the crystal structure of this compound determines characteristics of the alloy. However, this crystal structure is sensitive to the fabrication processes and easily changes depending upon conditions of the processes. Thus, it was quiet difficult to reproducibly fabricate the bismuth tellurium alloy and as a result it was difficult to keep the characteristic of the fabricated bismuth tellurium alloy constant.

It has been expected therefore to provide a new thermoelectric material that can resolve the problems of such conventional bismuth tellurium alloy, has thermoelectric characteristics equal to these of the bismuth tellurium alloy, has no toxicity, has no problem for the resources, and can easily keep the characteristic constant, and to provide a manufacturing method of the new thermoelectric material.

As for the manufacturing methods of the conventional thermoelectric material such as a magnesium silicon alloy or a magnesium silicon tin alloy, the SPS (Spark Plasma Sintering) method has been used in order to nominate the density of the alloy. This conventional manufacturing method of the thermoelectric material has processes of powdering the alloy, elevating temperature and pressure of the powdered alloy in high vacuum condition, and providing a large electric current thereto in a short time. However, this manufacturing method could not fabricate a cheap thermoelectric material in large quantities and thus the fabricated thermoelectric material became high-price.

It is therefore an object of the present invention to resolve the problems of the conventional thermoelectric material and to provide a thermoelectric material with a low thermal conductivity and a good insulation characteristic, a manufacturing method of the thermoelectric material, and a thermoelectric converter using the thermoelectric material.

MEANS TO SOLVE THE PROBLEMS

According to the present invention, provided is a thermoelectric material containing as a major ingredient a magnesium silicon tin alloy, and including a porous body with a large number of pores.

Since the thermoelectric material of the present invention contains a magnesium silicon tin alloy as a major ingredient and formed as a porous body, it is possible to extremely reduce the thermal conductivity and to improve the figure of merit Z. Also, it is possible to reduce the thickness of the thermoelectric converter due to the large fall of the thermal conductivity. As well as the reduction of the thickness, the volume of voids leads to reduction of used amount of the material resulting to conserve resources of the thermoelectric material. Further, because the thermal conductivity can be lowered due to the porous body, materials that have large thermal conductivities and thus have not been conventionally considered as a thermoelectric material such as for example silicon and germanium can be used.

It is preferred that the porous body has a porosity of 10 % to 80 %, more preferably a porosity of 30 % to 60 %. Thereby, it is possible to reduce the thermal conductivity and to keep a mechanical strength necessary for the thermoelectric material without largely increasing its electrical resistance.

According to the present invention, a manufacturing method of a thermoelectric material includes a process of powdering a raw material containing as a major ingredient a magnesium silicon tin alloy; a process of adding powdered additive agent of 5-20 WT% for forming a large number of pores to the raw material powdered in the powdering process, the added powdered additive agent being mixed with the powdered raw material and dispersed; a process of molding a mixture provided by the adding process; and a process of heating the mixture molded in the molding process in vacuum or an inert gas to a temperature of 550-800 °C (just under a melting point) to form a porous body.

The powdered additive agent is polyvinyl alcohol (PVA). Also, it is preferred that the method further includes a process of impregnating a liquid silicone resin or glass into the porous body formed by the heating process and of solidifying the impregnated porous body.

According to the present invention, further provided is a method of manufacturing a thermoelectric converter configured by electrically connecting in series a p-type thermoelectric material molded body and an n-type thermoelectric material molded body. The p-type thermoelectric material molded body and the n-type thermoelectric material molded body contain as a major ingredient a magnesium silicon tin alloy, and include a porous body with a large number of pores.

Thus, it is possible to extremely reduce the thermal conductivity resulting to reduce the thickness of the thermoelectric converter. As well as the reduction of the thickness, the volume of voids leads to reduction of used amount of the material resulting to conserve resources of the thermoelectric material.

It is preferred that the porous body has a porosity of 10 % to 80 %, more preferably a porosity of 30 % to 60 %. Thereby it is possible to reduce the thermal conductivity and to keep a mechanical strength necessary for the thermoelectric material without largely increasing its electrical resistance.

It is preferred that a plurality of pairs of the p-type thermoelectric material molded body and the n-type thermoelectric material molded body are electrically connected in series with each other to convert heat into electricity due to difference in temperature, and that the converter further includes a hot-side metal plate for coupling the p-type thermoelectric material molded body and the n-type thermoelectric material molded body that are adjacent with each other, a cold-side metal plate opposed to the hot-side metal plate, for coupling the p-type thermoelectric material molded body of one pair and the p-type thermoelectric material molded body of another pair adjacent to the above-mentioned one pair, an anode electrode extracted from the p-type thermoelectric material molded body, and a cathode electrode extracted from the n-type thermoelectric material molded body. Thereby bigger electromotive force can be obtained.

EFFECT OF THE INVENTION

According to the thermoelectric material of the present invention, it is possible to extremely reduce the thermal conductivity and to improve the figure of merit Z. Also, it is possible to reduce the thickness of the thermoelectric converter due to the large fall of the thermal conductivity. As well as the reduction of the thickness, the volume of voids leads to reduction of used amount of the material resulting to conserve resources of the thermoelectric material. Further, because the thermal conductivity can be lowered due to the porous body, materials that have large thermal conductivities and thus have not been conventionally considered as a thermoelectric material such as for example silicon, and germanium can be used.

According to the thermoelectric material of the present invention, since the powdered additive agent of 5-20 % for forming a large number of pores to the raw material powdered in the powdering process, is added to be mixed with the powdered raw material and dispersed, and then the mixture is heated to decompose, a uniform porous body can be easily provided.

According to the thermoelectric converter of the present invention, it is possible to extremely reduce the thermal conductivity resulting to reduce the thickness of the thermoelectric converter. As well as the reduction of the thickness, the volume of voids leads to reduction of used amount of the material resulting to conserve resources of the thermoelectric material.

BRIEF DESCRIPTION OF DRAWINGS

FIG. 1 is a perspective view schematically illustrating constitution of a thermoelectric converter in an embodiment according to the present invention;
FIG. 2 is a perspective view schematically illustrating constitution of a plurality of serially connected thermoelectric converters of the embodiment of FIG. 1;
FIG. 3 is a flow chart showing a manufacturing method of the thermoelectric material according to the present invention;
FIG. 4 is a sectional image view schematically illustrating structure of the thermoelectric material before a heating process according to the present invention;
FIG. 5 is a sectional image view schematically illustrating structure of the thermoelectric material according to the present invention;
FIG. 6 is a graph illustrating a relationship between an additive amount of PVA and a porosity of the thermoelectric material;
FIG. 7 is a graph illustrating comparison of dimensionless figure of merit ZT of the thermoelectric materials prepared by a manufacturing method of the present invention and by a conventional manufacturing method using the $Si_{0.95}Ge_{0.05}$ alloy;
FIG. 8 is a flow chart showing other manufacturing method of the thermoelectric material according to the present invention;
FIG. 9 is a graph illustrating comparison of dimensionless figure of merit ZT of the thermoelectric materials prepared by a manufacturing method of the present invention and by a conventional manufacturing method using the $Si_{0.8}Ge_{0.2}$ alloy;
FIG. 10 is a flow chart showing further manufacturing method of the thermoelectric material according to the present invention;
FIGS. 11A and 11B are sectional image views schematically illustrating structures of the thermoelectric material before and after heat treatment according to the present invention;
FIG. 12 is a graph illustrating a relationship between an additive amount of PVA powder and a porosity of the thermoelectric material;
FIG. 13 is a graph illustrating a relationship between an additive amount of PVA powder and change in a Seebeck coefficient of the n-type and p-type thermoelectric materials;
FIG. 14 is a graph illustrating a relationship between an additive amount of PVA powder and change in a thermal conductivity of the n-type and p-type thermoelectric materials;
FIG. 15 is a graph illustrating a relationship between an additive amount of PVA powder and change in an electrical resistivity of the n-type and p-type thermoelectric materials;
FIG. 16 is a graph illustrating a relationship between an additive amount of PVA powder and change in a dimensionless figure of merit of the n-type and p-type thermoelectric materials;
FIG. 17 is a graph illustrating a relationship between change in an electrical resistivity of the thermoelectric material shown in FIG. 11B and lapse of time in the atmosphere in case that silicone was impregnated or not impregnated into the thermoelectric material and dried; and
FIG. 18 is a graph illustrating a relationship between change in a thermal conductivity of the thermoelectric material shown in FIG. 11B and an additive amount of PVA powder in case that silicone was impregnated or not impregnated into the thermoelectric material and dried.

## BEST MODE EMBODIEMENT FOR CARRYING OUT THE INVENTION

Hereinafter, an embodiment of the thermoelectric converter according to the present invention will be described with reference to the appended drawings.

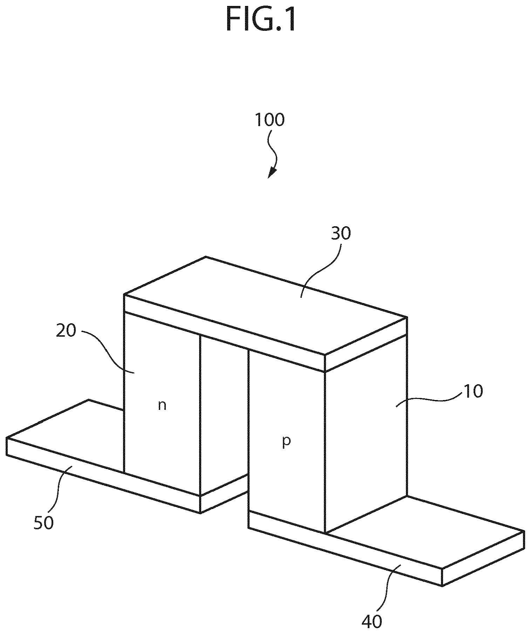

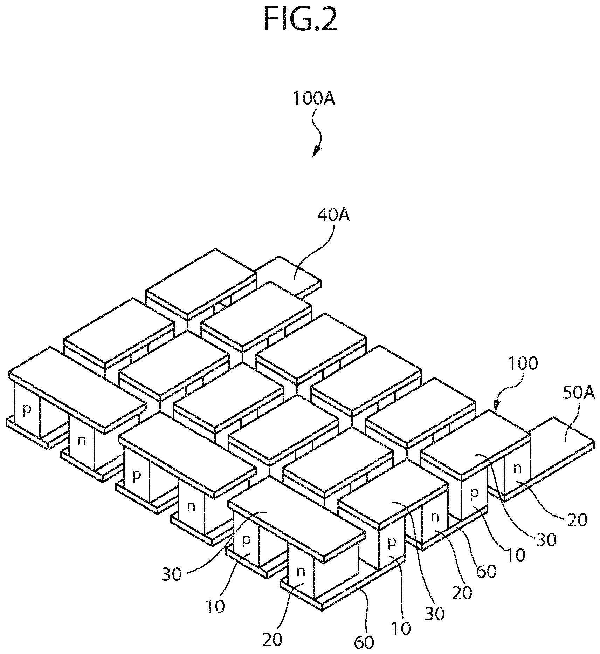

FIG. 1 schematically illustrates constitution of a thermoelectric converter 100 in a first embodiment according to the present invention, and FIG. 2 schematically illustrates constitution of a thermoelectric converter 100A configured by a plurality of the thermoelectric converters 100.

As shown in FIG. 1, the thermoelectric converter 100 of this embodiment has a p-type thermoelectric material molded body 10, a n-type thermoelectric material molded body 20, a hot-side metal plate 30 for coupling the p-type thermoelectric material molded body 10 and the n-type thermoelectric material molded body 20, an anode electrode 40 extracted from the p-type thermoelectric material molded body 10, and a cathode electrode 50 extracted from the n-type thermoelectric material molded body 20.

As shown in FIG. 2, in a thermoelectric converter 100A constituted by of a plurality of thermoelectric converters 100, each thermoelectric converter 100 consists of the p-type thermoelectric material molded body 10, the n-type thermoelectric material molded body 20, the hot-side metal plate 30 for coupling the p-type thermoelectric material molded body 10 and the n-type thermoelectric material molded body 20. The p-type thermoelectric material molded body 10 of one thermoelectric converter 100 and the n-type thermoelectric material molded body 20 of an adjacent thermoelectric converter 100 are coupled by a cold-side metal plate 60 that is opposed to the hot-side metal plate 30. Also, in the thermoelectric converter 100A, an anode electrode 40A extracted from the p-type material molded body 10 located at an anode extracting edge, and a cathode electrode 50A extracted from the n-type material molded body 20 located at a cathode extracting edge are provided.

The p-type thermoelectric material molded body 10 according to the present invention is formed from a porous body with a lot of pores containing as a major ingredient either of a magnesium silicon alloy, a magnesium silicon tin alloy, a silicon or a silicon germanium alloy. That is, first, a raw material of the p-type thermoelectric material is formed by adding an additive agent (dopant) such as boron or else into the major ingredient either of a magnesium silicon alloy, a magnesium silicon tin alloy, a silicon or a silicon germanium alloy, then, a porous body having a lot of pores is formed, thereafter, this porous body is cut into rectangle bodies each having a predetermined size so as to obtain the p-type thermoelectric material molded body 10. It is desired that the porous body has a porosity of 10% to 80%. Specific manufacturing processes of the p-type thermoelectric material molded body 10 will be described later.

The n-type thermoelectric material molded body 20 according to the present invention is formed from a porous body with a lot of pores containing as a major ingredient of a magnesium silicon tin alloy. That is, first, a raw material of the n-type thermoelectric material is formed by adding an additive agent (dopant) into the major ingredient of a magnesium silicon tin alloy, then, a porous body having a lot of pores is formed, thereafter, this porous body is cut into rectangle bodies each having a predetermined size so as to obtain the n-type thermoelectric material molded body 20. It is desired that the porous body has a porosity of 10% to 80%. Specific manufacturing processes of n-type thermoelectric material molded body 20 will be described later.

The hot-side metal plate 30 electrically couples the p-type thermoelectric material molded body 10 and the n-type thermoelectric material molded body 20. This hot-side metal plate 30 is fixed to the end portion of the p-type thermoelectric material molded body 10 and the end portion of the n-type thermoelectric material molded body 20. As for fixing of the hot-side metal plate 30, used is the welding method utilizing a metal material that will not melt in the operating temperature range.

The anode electrode 40 and the anode electrode 40A are electrodes extracted from the p-type thermoelectric material molded bodies and fixed to the end portions of the p-type thermoelectric material molded bodies 10.

The cathode electrode 50 and the cathode electrode 50A are electrodes extracted from the n-type thermoelectric material molded bodies and fixed to the end portions of the n-type thermoelectric material molded bodies 20.

In the thermoelectric converter 100A constituted by a plurality of thermoelectric converters 100, each of the cold-side metal plates 60 electrically couples, at the side opposed to the hot-side metal plates 30, the p-type thermoelectric material molded body 10 of one thermoelectric converter 100 and the n-type thermoelectric material molded body 20 of an adjacent thermoelectric converter 100. This cold-side metal plate 60 is fixed to the end portion of the p-type thermoelectric material molded body 10 and the end portion of the n-type thermoelectric material molded body 20.

In each thermoelectric converter 100 thus configured, the upper side is the hot-side and the lower side is the cold-side. In the upper hot-side, electrons strenuously exercise and scatter to the cold-side in the n-type thermoelectric material molded body 20, and holes strenuously exercise and scatter to the cold-side in the p-type thermoelectric material molded body 10. As a result, a potential difference will be produced between the anode electrode 40 and the cathode electrode 50.

Because the thermos-electromotive force generated from the single thermoelectric converter 100 is small, a plurality of thermoelectric converters 100 are connected in series, like the thermoelectric converter 100A shown in FIG. 2, to provide a relatively big electromotive force (several volts for example).

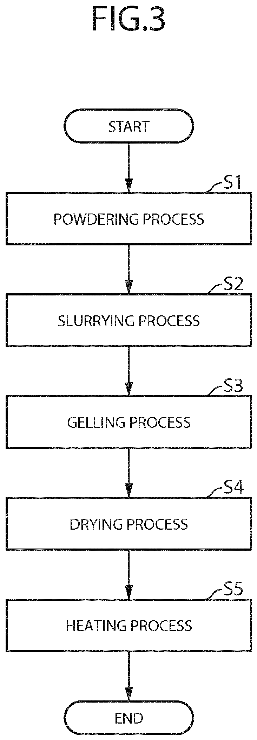

Hereinafter, the manufacturing method of the thermoelectric material according to the present invention will be described. FIG. 3 shows a main manufacturing method of the thermoelectric material according to the present invention

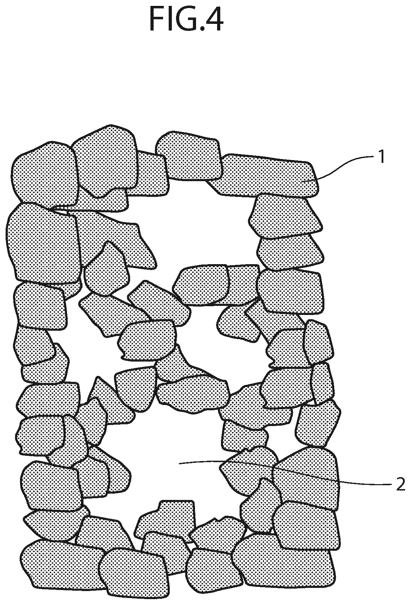

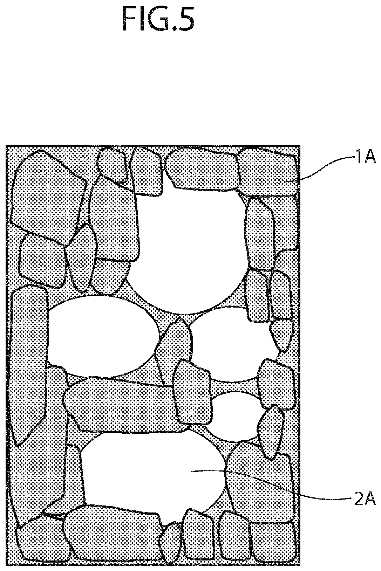

As shown in FIG. 3, at first, a raw material is powdered at a powdering process (S1). As for the raw material, a magnesium silicon tin alloy, with a dopant material such as an antimony, for example for fabricating the p-type or n-type thermoelectric material is used. Then, a water solution of a polyvinyl alcohol (PVA) is added to the powdered raw material to form a slurry raw material at a slurrying process (S2). Then, at a gelling process (S3), the slurry raw material is cast in molds and cooled at -10 °C to turn into a gel. Then, at a drying process (S4), the raw material gelated is removed from the molds, and heated in the atmosphere for 24 hours at 60 °C to evaporate the water. Thereafter, the raw material is left unattended in the atmosphere for 12 hours at 120 °C to completely evaporate the water. Thus, air will enter into portions in the powder, from which the water came out, to form a porous body. FIG. 4 shows the inside state of this porous body. In FIG. 4, reference numeral 1 denotes a solidified powder, and 2 denotes a pore of the porous body. Finally, thus fabricated porous body is heated to a predetermined temperature in vacuum or inert gases at a heating process (S5). Due to this heating process, shapes of a large number of the powder particles of the porous body are kept as they are, but the surfaces of a part of the powder particles are molten to couple with the adjacent powder particles. As a result, a low-resistive and high-strength porous body of the alloy can be provided. FIG. 5 shows the inside state of this porous body of the magnesium silicon tin alloy. As shown in FIG. 5, it is seen that the surfaces of a part of the powder particles are molten to couple with the adjacent powder particles. In this figure, reference numeral 1A denotes the powder particle a part of which is dissolved, and 2A denotes a pore of the porous body. Hereinafter, concrete examples will be described.

[Example 1]

An n-type thermoelectric material was fabricated using the melting method by adding an antimonial (Sb) into a magnesium silicon tin alloy (Mg-Si-Sn alloy). Then, the fabricated thermoelectric material was powdered and thereafter a water solution of PVA was added to the powder to form a slurry. The slurry was cast in molds and cooled at -10 °C to turn into a gel, and then the gel was removed from the molds and heated in the atmosphere for 24 hours at 60 °C to evaporate the water. Thereafter, the heated gel was left unattended in the atmosphere for 12 hours at 120 °C to completely evaporate the water. Then, air would enter into portions in the powder, from which the water came out, to form a porous body.

Next, the fabricated porous body was heated to a predetermined temperature in vacuum or inert gases. While this heating, shapes of a large number of the powder particles of the porous body were kept as they were, but the surfaces of a part of the powder particles were molten to couple with the adjacent powder particles. As a result, a low-resistive and high-strength porous body of magnesium silicon tin alloy could be provided. FIG. 5 shows the inside state of this porous body.

A porosity $\alpha$ of the porous body is defined as follows:

$$\alpha = Va / (Vm+Va)$$

here, Va indicates a volume of the voids, and Vm indicates a volume of the material.

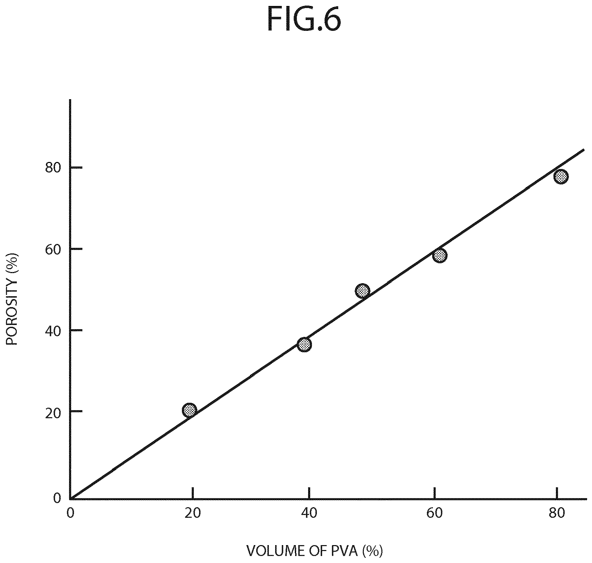

The porosity $\alpha$ will be given from the quantity of the water solution of added PVA. The porosity $\alpha$ of the porous body fabricated by adding a 10% water solution of the PVA to the powdered raw material to form a slurry raw material, by freezing the slurry raw material to turn into a gel, by drying the gel, and by heating the dried material is shown in FIG. 6. In FIG. 6, "VOLUME OF PVA" means the volume of the water solution of the added PVA powder. The desired porosity $\alpha$ was provided by adjusting the amount of the water solution of the PVA in this way.

In case that the porosity is less than 10%, the porous body will have characteristics approximately similar to that of the non-porous body material, namely of the conventional thermoelectric material (ingot material) and no effect to reduce the thermal conductivity will be provided. On the other hand, in case that the porosity is more than 80%, the porous body will have a larger electrical resistivity and a weak material-strength, and thus, it will be hard to use for the thermoelectric material. Therefore, it is desired that, as for the thermoelectric material, the porosity is within a range of 10% to 80%.

A thermoelectric material with a porosity of 50% was fabricated from the raw material of $Mg_2Si_{0.3}Sn_{0.7}$ with the addition of 0.01 mol of Sb by the method of Example 1. The fabricated thermoelectric material had the following characteristics under about 700 K (427 °C) :

Seebeck coefficient S = -250 $\mu$V/K
Electrical resistivity $\rho$ = 7.1 $\times$ 10$^{-5}$ Qm
Thermal conductivity $\kappa$ = 0.40 W/Km.

From these characteristics, a high figure of merit Z of 2.23 $\times$ 10$^{-3}$ K$^{-1}$ was obtained and dimensionless figure of merit ZT = 1.56 was provided. Although the electrical resistivity was increased due to a large number of pores formed in the porous body, influence of falling of the thermal conductivity was bigger than that of the electrical resistivity increase and, as a result, a large figure of merit Z was obtained.

[Example 2] (not according to the present invention)

An ingot was fabricated by mixing boron of 0.2 atom % with silicon, and by dissolving it in an inert gas without oxygen or in a vacuum. The fabricated ingot was crushed with hammers and then powdered using a ball mill. Thereafter, a water solution of PVA was added to the powder to form a slurry. The added PVA was adjusted so that the porosity became 70 %. Then, the slurry was cast in molds and heated in the atmosphere for 24 hours at 60 °C to evaporate the water. Further, it was heated in the atmosphere for 12 hours at 120 °C to completely evaporate the water. Thus, air would enter into portions in the powder, from which the water came out, to form a porous body. Thereafter, the dried porous body was heated in a vacuum at a predetermined temperature, and then cooled. As a result, a porous body of silicon with a porosity of 70 % was formed as a p-type thermoelectric material.

By using the similar fabrication method mentioned above, an ingot was fabricated by mixing phosphorus of 0.3 atom % with silicon, and by dissolving it in an inert gas without oxygen or in a vacuum, and the fabricated ingot was crushed with hammers and then powdered using a ball mill. Thereafter, a water solution of PVA was added to the powder to form a slurry. The added PVA was adjusted so that the porosity became 70 %. Then, the slurry was cast in molds and heated in the atmosphere for 24 hours at 60 °C to evaporate the water. Further, it was heated in the atmosphere for 12 hours at 120 °C to completely evaporate the water. Thus, air would enter into portions in the powder, from which the water came out, to form a porous body. Thereafter, the dried porous body was heated in a vacuum at a temperature that would not exceed a melting point of silicon (1,414 °C), and then cooled. As a result, a porous body of silicon with a porosity of 70 % was formed as an n-type thermoelectric material.

The electrical resistivity of the fabricated porous body of the silicon, that is the p-type thermoelectric material, was $1 \times 10^{-4}$ Ωm. This electrical resistivity is equivalent to 10 times or more than that of the p-type silicon bulk. On the other hand, the thermal conductivity was greatly lowered to 1 W/Km. This thermal conductivity is hundredth part of that of the p-type silicon bulk. Also, due to the porous body, the Seebeck coefficient was not fallen but risen. Approximately similar results were obtained with respect to the porous body of the n-type silicon.

Because influence of falling of the thermal conductivity was bigger than that of the electrical resistivity increase, a dimensionless figure of merit ZT larger than that of the thermoelectric material (nonporous body) was obtained. As a result, the dimensionless figure of merit ZT became ZT = 0.22 that is a level usable as the thermoelectric material.

The p-type and n-type silicon porous bodies fabricated by the aforementioned processes were cut into cubes of 1 cm, respectively, to form pn-junction thermoelectric converters shown in FIG. 1. With respect to this thermoelectric converter, when the temperature of the hot side was set at 100 °C and the temperature of the cold side was set at 0 °C, it was observed that the electromotive force measured was approximately 30 mV.

[Example 3] (not according to the present invention)

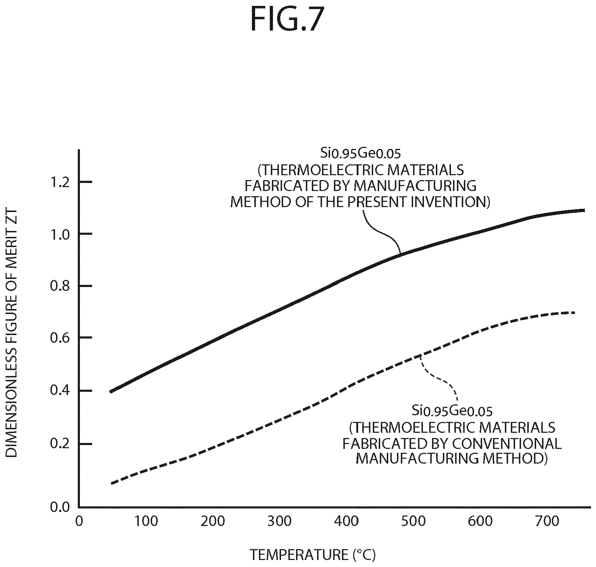

P-type and n-type thermoelectric materials were fabricated by using the manufacturing method similar to that of Example 2 except that a silicon germanium alloy ($Si_{0.95}Ge_{0.05}$ alloy) was used instead of the silicon in Example 2. Due to this difference of the raw material used, the heat-treatment temperature of a dried porous body in a vacuum or inert gases in this Example 3 was set in a temperature region in which the liquid phase and the solid phase of the silicon germanium alloy are coexisting. By executing this heat-treatment, a part (surface) of the powder particles of the silicon germanium alloy was dissolved to form a continuous body as shown in FIG. 5 so as to lower the electrical resistance. The heat conduction was lowered more than that of Example 2 due to the effect of addition of germanium, and a dimensionless figure of merit ZT over 1.0 was provided as shown in FIG. 7. In FIG. 7, the solid line indicates a curve of the dimensionless figure of merit ZT of the thermoelectric material fabricated by the manufacturing method of the present invention, and the broken line indicates a curve of the dimensionless figure of merit ZT of the thermoelectric material fabricated by the conventional manufacturing method.

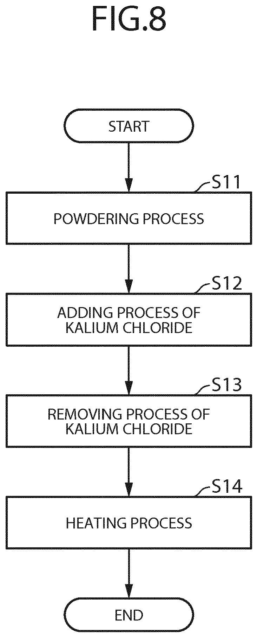

FIG. 8 shows other manufacturing method of the thermoelectric material according to an example. As shown in the figure, at first, a raw material is powdered at a powdering process (S11). As for the raw material, either of a magnesium silicon alloy, a magnesium silicon tin alloy, a silicon or a silicon germanium alloy with a dopant material such as an antimony, a phosphorus or a boron for example for fabricating the p-type or n-type thermoelectric materials is used. Then, powder of kalium chloride is added to the powdered raw material and, after having mixed, and molded with pressure at an adding process of kalium chloride (S12). Then, the raw material with the added kalium chloride is heated at 770 °C that is just under the melting point of kalium chloride and, after having cooled off, dipped in the water to remove the added kalium chloride at a removing process of kalium chloride (S13) . Thus, air will enter into portions in the powder, from which the water came out, to form a porous body. FIG. 4 shows the inside state of this porous body. Finally, thus fabricated porous body is heated to a predetermined temperature in vacuum or inert gases at a heating process (S14) . As a result, a low-resistive and high-strength porous body of the alloy can be provided. FIG. 5 shows the inside state of this porous body of the magnesium silicon tin alloy.

[Example 4]

In this Example 4, a silicon germanium alloy ($Si_{0.8}Ge_{0.2}$ alloy) was used instead of the silicon in Example 2 and a powder of kalium chloride was used instead of the PVA in Example 2. The powder of kalium chloride was mixed with a powder of the silicon germanium alloy, and pressurized to harden the mixture. Then, the mixture with the added kalium chloride was heated at 770 °C that is just under the melting point of kalium chloride and, after having cooled off, dipped in the water to remove the added kalium chloride. After the kalium chloride was removed, the fabricated porous body was heated to a predetermined temperature in a vacuum. As a result, a porous body of magnesium silicon alloy could be provided as the p-type and n-type thermoelectric materials.

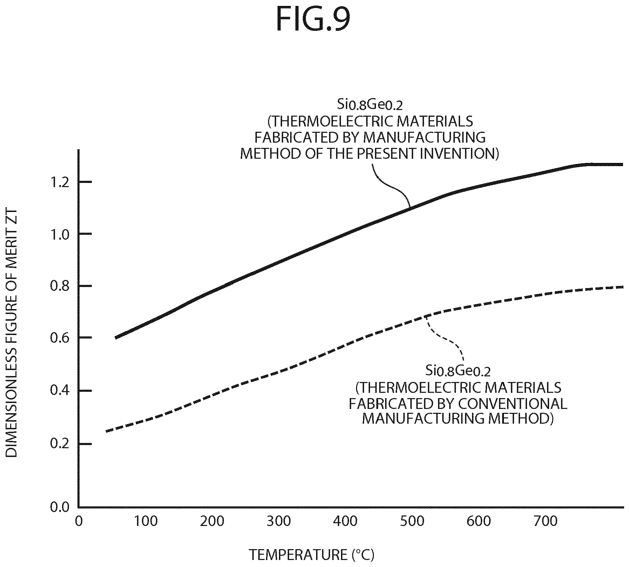

The provided thermoelectric material had the structure as shown in FIG. 5. The heat conduction of the thermoelectric material was lowered more than that of Example 2 and Example 3, and a dimensionless figure of merit ZT thereof was improved as shown in FIG. 9. In FIG. 9, the solid line indicates a curve of the dimensionless figure of merit ZT of the thermoelectric material fabricated by the manufacturing method of the present invention, and the broken line indicates a curve of the dimensionless figure of merit ZT of the thermoelectric material fabricated by the conventional manufacturing method.

In Example 3 and Example 4, the silicon germanium alloy was used. Although the germanium was high-priced, because the thermoelectric material was made as a porous body, the entered air in the porous body was served to save the amount of the germanium used. Also, the thickness of the thermoelectric material could be reduced due to the lowered heat conduction, resulting to save the amount of the material used. Due to the fabrication of the porous body, it was possible to save the amount of material used and to contribute to the cost reduction of the thermoelectric material.

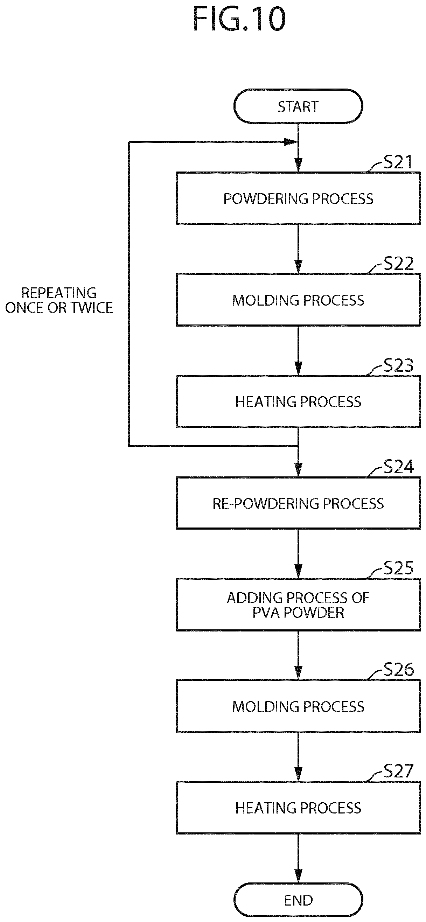

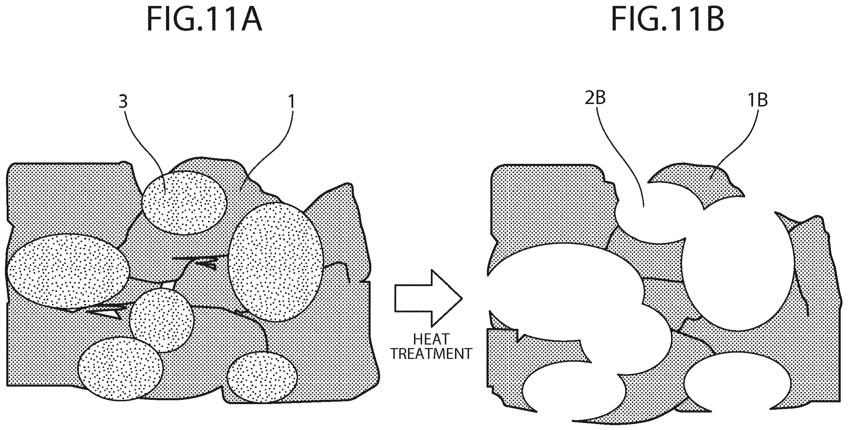

FIG. 10 shows further manufacturing method of the thermoelectric material according to the present invention. As shown in the figure, at first, a raw material is powdered at a powdering process (S21). As for the raw material, a magnesium silicon tin alloy, for example for fabricating p-type or n-type thermoelectric materials is used. It is desired that crushing and mixing is conducted in inert gases. Then, the powdered raw material is molded to have a predetermined shape at a molding process (S22). Then, the molded raw material is heated to 600-750 °C in a vacuum or inert gases at a heating process (S23). The processes S21-S23 are repeated once or twice so that the whole material becomes uniform in composition. Then, the molded raw material after the heat treatment is crushed again at a re-powdering process (S24). Then, a powder additive of 5-20 WT% of the PVA powder for example is mixed and scattered in the re-powdered raw material at an adding process of PVA powder (S25). If the adding PVA is less than 5 %, no expected reduction in the thermal conduction can be obtained. On the other hand, if the adding PVA is more than 20 %, the provided thermoelectric material will become weak in mechanical strength and will become fragile. Then, the mixture material with which powder of the organic solvent or the foaming agent was mixed is molded to form a predetermined shape at a molding process (S26). Then, the molded mixture material is heated or sintered to 550-800 °C at a heating process (S27). If the sintering temperature is less than 550 °C, a solid-phase reaction will not proceed resulting that no crystal structure for providing the thermoelectric properties can be obtained. On the other hand, if the sintering temperature is more than 800 °C, generation of the compound that is the subject of the thermoelectric material is difficult and the crystal structure showing thermoelectric properties is broken. Therefore, it is desired that the sintering temperature is equal to 550 °C, equal to 800 °C, or more than 550 °C and less than 800 °C. By sintering or heating the mixture material to 550-800 °C, a powder of the organic solvent or the foaming agent in the mixture material will be disintegrated and vaporized to form a porous body with a lot of pores as shown in FIGS. 11A and 11B.

In the heating process, the PVA begins the resolution to oxygen, hydrogen and carbon at around 200 °C. Oxygen and hydrogen will evaporate from the alloy at 200-300 °C but carbon will remain in the alloy. This carbon will be scattered by the high-temperature heat treatment to some extent but will remain in the alloy up to around 800 °C. The volume of the remained carbon is however extremely small, and portions in the alloy, from which oxygen and hydrogen were evaporated, become cavities or air bubbles.

FIG. 11A indicates a state before the heat treatment, and FIG. 11B indicates a state after the heat treatment. In the figures, reference numeral 1 denotes a powder of the thermoelectric material, 3 denotes a powder of the PVA, 1B denotes a thermoelectric material solid-phased from the powder, and 2B denotes a cavity formed caused by the disintegration and vaporization of the PVA.

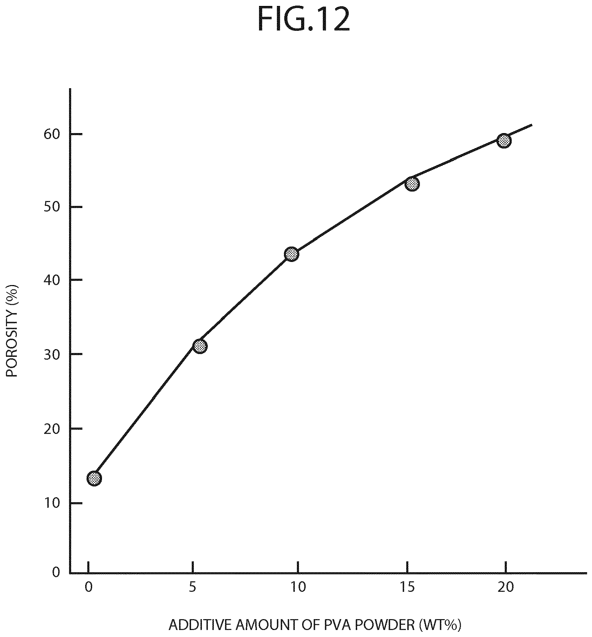

FIG. 12 shows a relationship between an additive amount of the PVA powder and a porosity $\alpha$ of the porous body. In the figure, "ADDITIVE AMOUNT OF PVA POWDER" means a weight percent (WT%) of added powder of the PVA. As will be noted from this figure, a desired porosity $\alpha$ was obtained by adjusting the amount of addition of the PVA powder. More concretely, in case that the additive amount of PVA powder is 5-20 %, the porosity $\alpha$ of the fabricated porous body will become in a range of 30-60 % as shown in FIG. 12. That is, it is desired that the additive amount of the PVA powder is adjusted so that the porosity $\alpha$ becomes equal to 30 %, equal to 60 %, or more than 30 % and less than 60 %.

[Example 5]

A powder of magnesium of 36.5 WT%, a powder of silicon of 5.5 WT%, and a powder of tin of 58.0 WT% were mixed, an antimonial powder of 0.85 WT% was added as a n-type dopant to these mixed powders, and then these powders were mixed and crushed. The mixed and crushed raw material was pressurized and molded, and the molded raw material was sintered at a temperature of 700 °C in a vacuum or inert gases. The sintered raw material was crushed again into powder, then the powdered raw material was pressurized and molded again, and thereafter the molded raw material was sintered at temperature of 700 °C in a vacuum or inert gases again. The re-sintered raw material was crushed again into powder. Then, a powder of the PVA of 5-20 %WT was added to the powdered raw material as an additive powder, and mixed enough. Thus fabricated mixture was pressurized and molded, and the molded mixture was sintered at a temperature of 750 °C in a vacuum or inert gases. By sintering or heating the mixture material, the powder of the PVA in the mixture material was disintegrated and vaporized, and then n-type porous thermoelectric material with a lot of pores was obtained.

By using the similar manufacturing method as mentioned above, a powder of magnesium of 32.8 WT%, a powder of silicon of 6. 6 WT%, and a powder of tin of 60. 6 WT% were mixed, a silver powder of 0.78 WT% was added as a p-type dopant to these mixed powders, and then these powders were mixed and crushed. The mixed and crushed raw material was pressurized and molded, and the molded raw material was sintered at a temperature of 700 °C in a vacuum or inert gases. The sintered raw material was crushed again into powder, then the powdered raw material was pressurized and molded again, and thereafter the molded raw material was sintered at temperature of 700 °C in a vacuum or inert gases again. The re-sintered raw material was crushed again into powder. Then, a powder of the PVA of 5-20 %WT was added to the powdered raw material as an additive powder, and mixed enough. Thus fabricated mixture was pressurized and molded, and the molded mixture was sintered at a temperature of 750 °C in a vacuum or inert gases. By sintering or heating the mixture material, the powder of the PVA in the mixture material was disintegrated and vaporized, and then p-type porous thermoelectric material with a lot of pores was obtained.

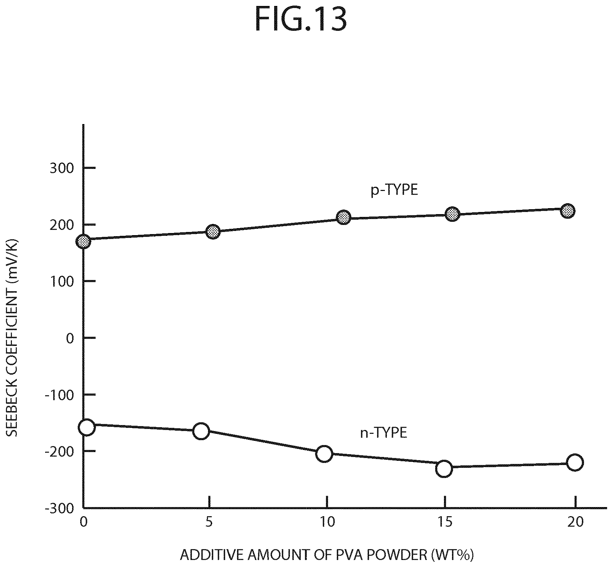

Characteristics of thus fabricated n-type and p-type thermoelectric materials were examined. FIG. 13 illustrates the examined relationship between an additive amount of PVA powder and change in Seebeck coefficients of the n-type thermoelectric material made of Sb doped MgSiSn alloy and of the p-type thermoelectric material made of Ag doped MgSiSn alloy. As shown in FIG. 13, the Seebeck coefficients was slightly decreased to the negative direction in accordance with increase in the additive amount of the PVA in case of the n-type thermoelectric material, and slightly increased to the positive direction in accordance with increase in the additive amount of the PVA in case of the p-type thermoelectric material.

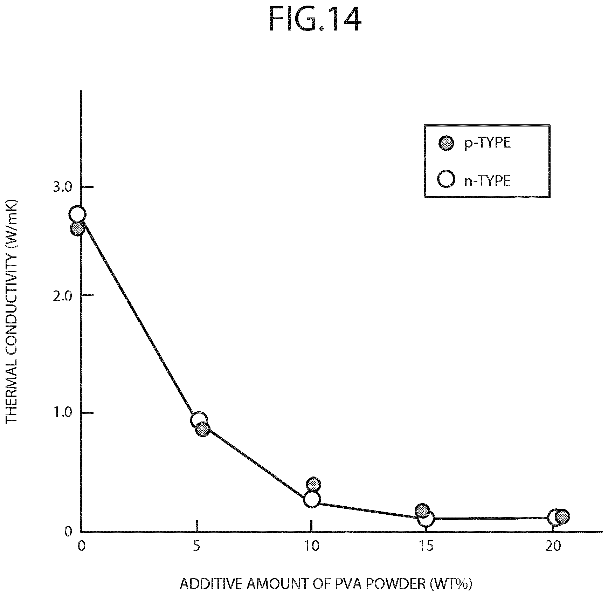

FIG. 14 illustrates the examined relationship between an additive amount of PVA powder and change in a thermal conductivity of the n-type thermoelectric material made of Sb doped MgSiSn alloy and of the p-type thermoelectric material made of Ag doped MgSiSn alloy. As shown in FIG. 14, the thermal conductivity of both the n-type and p-type thermoelectric materials greatly decreased in accordance with increase in the additive amount of the PVA. This lowering of the thermal conductivity might be caused by increase in the volume of the cavity shown in FIG. 11B in accordance with the additive amount of the PVA. If the additive amount of the PVA exceeds 10%, the thermal conductivity lowers to around tenth part.

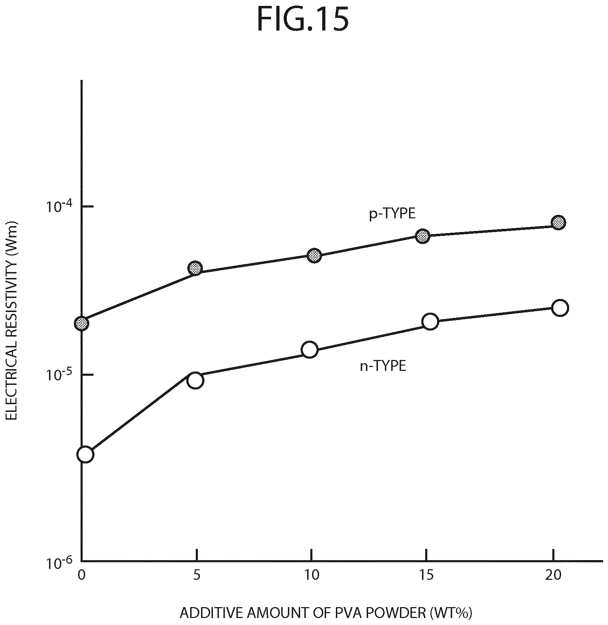

FIG. 15 illustrates the examined relationship between an additive amount of PVA powder and change in an electrical resistivity of the n-type thermoelectric material made of Sb doped MgSiSn alloy and of the p-type thermoelectric material made of Ag doped MgSiSn alloy. As shown in FIG. 15, the electrical resistivity of both the n-type and p-type thermoelectric materials increased in accordance with increase in the additive amount of the PVA. However, a ratio of change in the electrical resistivity (shown in FIG. 15) was not larger than a ratio of change in thermal conductivity (shown inFIG. 14) . It should be noted that the electrical resistivity and the thermal conductivity of the porous body will not be determined merely from an area ratio of the conductive portion and the cavity in the section of the porous body, but will be determined from the conduction mechanism of the porous body. Therefore, the thermal conductivity changed greatly but the electrical resistivity changed small.

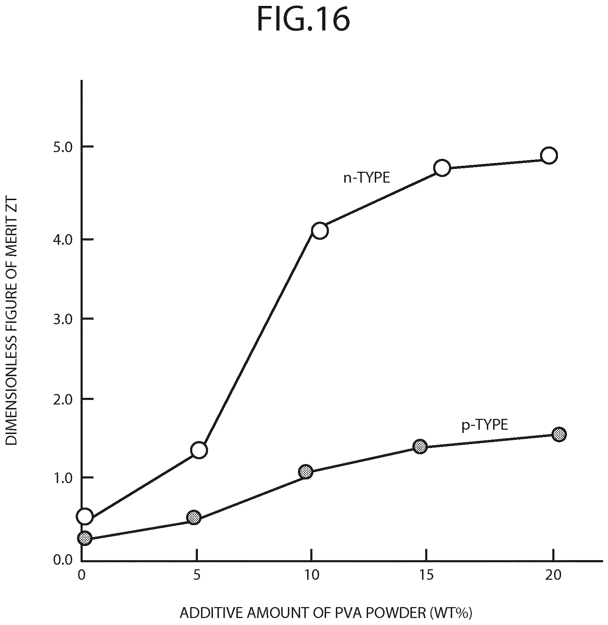

A dimensionless figure of merit could be calculated from the abovementioned result. FIG. 16 shows the result of calculation of a formula of;

$$ZT = (S^2/\rho\kappa) \times T$$

when the results from FIG. 11 to FIG. 15 were substituted to the formula. As shown in FIG. 16, in case that the additive amount of the PVA was over 10 %, the dimensionless figure of merit ZT of the n-type thermoelectric material made of Sb doped MgSiSn alloy exceeded 4.0, and it was proved that the thermoelectric material thus fabricated had reached the performance capable of adopting for electrical generation usage. Also, in case that the additive amount of the PVA was over 10 %, the dimensionless figure of merit ZT of the p-type thermoelectric material made of Ag doped MgSiSn alloy exceeded 1.0. Thus, as for both the n-type and p-type thermoelectric materials, the results of practical use were obtained.

[Example 6] (not according to the present invention)

A powder of magnesium of 63.4 WT%, and a powder of silicon of 36.6 WT% were mixed, a phosphorus powder of 0.9 WT% was added as a n-type dopant to these mixed powders, and then these powders were mixed and crushed. The mixed and crushed raw material was pressurized and molded, and the molded raw material was sintered at a temperature of 500-850 °C in a vacuum or inert gases. As a result, the sintered raw material was weak and often powdered when the sintered temperature was equal to 550 °C or less, or equal to 810 °C or more. Therefore, it was apparent that the thermoelectric material according to the present invention was provided only when the sintered temperature was in a range equal to 600 °C or more and equal to 800 °C or less. The reasons of this result are caused by that no crystalline rearrangement occurs and the powder will not be combined when the sintered temperature is less than 600 °C, and also that anti-fluorite structure of compound $Mg_2X$ (X = Si, Ge, Sn) which draws material characteristics of the present invention cannot be stably existed when the sintered temperature is more than 800 °C. Therefore, the aforementioned temperature range is a heat-treatment temperature range common for both the magnesium silicon alloy and the magnesium silicon tin alloy.

[Example 7]

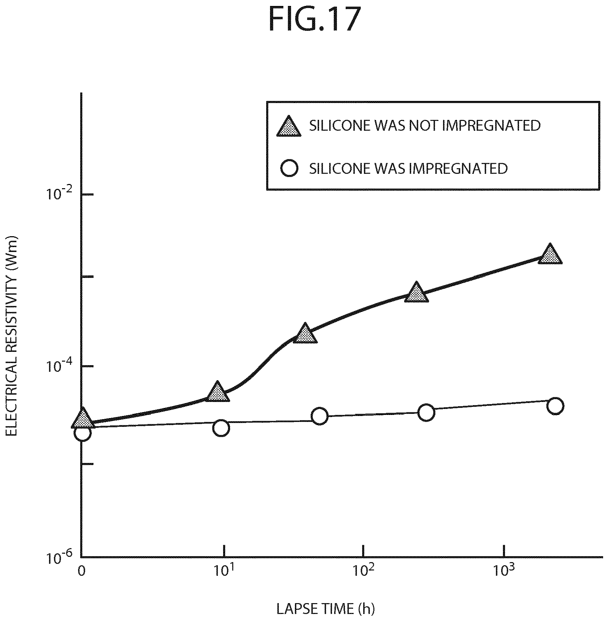

The porous body of the thermoelectric material according to the present invention, including magnesium, is fabricated by forming pores with air therein and therefore easily influenced by oxygen and water in the air. In order to prevent such influence, the thermoelectric material was impregnated in a silicone series resin with a viscosity of 100 or less and then solidified. Alternatively, the thermoelectric material was impregnated in a low-melting point-glass and then solidified. Due to such treatment, a corrosion resistance of the thermoelectric material and/or the thermoelectric converter according to the present invention was largely improved. FIG. 17 illustrates a relationship between changes in an electrical resistivity of the n-type thermoelectric material of Example 1 and lapse of time in case that the silicone series resin was impregnated and the impregnated thermoelectric material was solidified and then the material was left unattended in the atmosphere, and that the silicone series resin was not impregnated and the thermoelectric material was not solidified and then the material was left unattended in the atmosphere. As shown in FIG. 17, the electrical resistivity was not increased as for the treated material (silicone was impregnated) with the lapse of time, but the electrical resistivity was increased as for the untreated material (silicone was not impregnated) with the lapse of time.

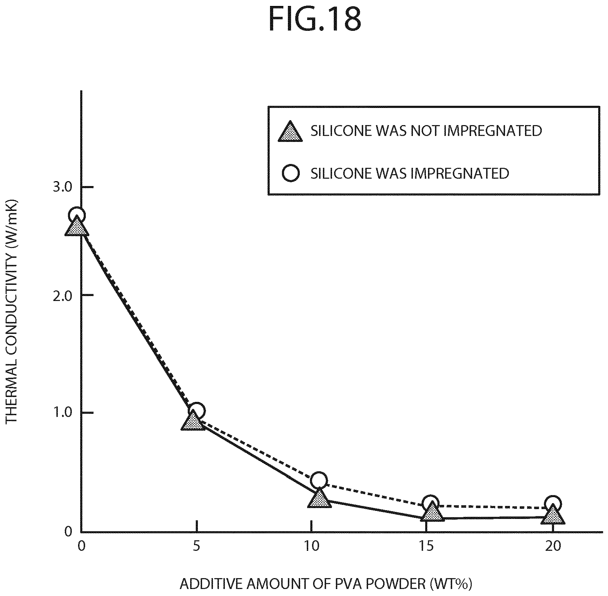

As aforementioned, no electrical resistivity change was seen in the material into which the silicone series resin was impregnated and was solidified. Similar to this, no big change was seen about the thermal characteristics such as the thermal conductivity either. FIG. 18 illustrates a relationship between changes in a thermal conductivity of the n-type thermoelectric material of Example 1 and an additive amount of PVA powder in case that the silicone series resin was impregnated and the impregnated thermoelectric material was solidified and then the material was left unattended in the atmosphere, and that the silicone series resin was not impregnated and the thermoelectric material was not solidified and then the material was left unattended in the atmosphere. As shown in FIG. 18, the thermal conductivities did not differ between the treated material (silicone was impregnated) and the untreated material (silicone was not impregnated). Therefore, it was understood that the impregnation of the silicone series resin into the thermoelectric material improved the anti-wheatherability and provided no bad influence in the thermoelectric characteristics.

As discussed above, the thermoelectric converter 100 according to the present embodiment has the p-type thermoelectric material molded body 10, the n-type thermoelectric material molded body 20, the hot-side metal plate 30 for coupling the p-type thermoelectric material molded body 10 and the n-type thermoelectric material molded body 20, the anode electrode 40 extracted from the p-type thermoelectric material molded body 10, and the cathode electrode 50 extracted from the n-type thermoelectric material molded body 20. The p-type thermoelectric material molded body 10 and the n-type thermoelectric material molded body 20 are formed from porous bodies with a lot of pores and with a porosity of 10% to 80%, more desirably a porosity of 30% to 60%, containing as a major ingredient either of a magnesium silicon alloy, a magnesium silicon tin alloy, a silicon or a silicon germanium alloy.

Thus, the thermoelectric material can extremely reduce the thermal conductivity and to improve the figure of merit Z. Also, it is possible to reduce the thickness of the thermoelectric converter due to the large fall of the thermal conductivity. As well as the reduction of the thickness, the volume of voids leads to reduction of used amount of the material resulting to conserve resources of the thermoelectric material. Further, because the thermal conductivity can be lowered due to forming in a porous body, the material that has large thermal conductivities and thus was not conventionally considered as the thermoelectric material such as for example silicon, and germanium can be used.

As aforementioned, the thermoelectric converters 100 and 100A using the thermoelectric material according to the present invention can reduce the thickness of the thermoelectric converter due to the large lowering of the thermal conductivity. In addition to the reduction of the thickness, the volume of voids leads to reduction of the used amount of the material resulting to conserve resources of the thermoelectric material.

INDUSTRIAL APPLICABILITY

The present invention is applicable for the electrical generation using difference in temperature, and for producing difference of temperature from the electric energy.

**Claims**

1. A manufacturing method of a thermoelectric material containing as a major ingredient a magnesium silicon tin alloy and comprising a porous body with pores, **characterized in that** said method comprises:

   a process of powdering (S1) a raw material (1,1A) containing as a major ingredient a magnesium silicon tin alloy;
   a process of adding a powdered additive agent of 5-20 WT% for forming pores (2, 2A) to the raw material powdered in the powdering process, said added powdered additive agent being mixed with the powdered raw material and dispersed, wherein the powdered additive agent is polyvinyl alcohol (3) ;
   a process of molding a mixture provided by the adding process; and
   a process of heating (S5) the mixture molded in the molding process in vacuum or an inert gas to a temperature of 550-800 °C to form a porous body.

2. The manufacturing method of a thermoelectric material as claimed in claim 1, wherein the method further comprises a process of impregnating a liquid silicone resin or glass to the porous body formed by the heating process to solidify the porous body.

3. A manufacturing method of a thermoelectric converter (100) configured by electrically connecting in series a p-type thermoelectric material molded body (10) containing as a major ingredient a magnesium silicon tin alloy and comprising a porous body with pores, and an n-type thermoelectric material molded body (20) containing as a major ingredient a magnesium silicon tin alloy and comprising a porous body with pores, wherein said method comprises preparing said p-type and n-type thermoelectric materials according to the method of claim 1 or claim 2.

**Patentansprüche**

1. Verfahren zur Herstellung eines thermoelektrischen Materials, das als Hauptbestandteil eine Magnesium-Silicium-Zinn-Legierung enthält und einen porösen Körper mit Poren umfasst, **dadurch gekennzeichnet, dass** das genannte Verfahren Folgendes beinhaltet:

   einen Prozess des Pulverisierens (S1) eines Rohmaterials (1, 1A), das als Hauptbestandteil eine Magnesium-Silicium-Zinn-Legierung enthält;
   einen Prozess des Hinzufügens eines pulverisierten Zusatzstoffs von 5-20 Gew.-% zum Bilden von Poren (2, 2A) zu dem im Pulverisierungsprozess pulverisierten Rohmaterial, wobei der genannte hinzugefügte pulverisierte Zusatzstoff mit dem pulverisierten Rohmaterial gemischt und dispergiert wird, wobei der pulverisierte Zusatzstoff Polyvinylalkohol (3) ist;
   einen Prozess des Formens eines durch den Zugabeprozess bereitgestellten Gemischs; und
   einen Prozess des Erhitzens (S5) des im Formprozess geformten Gemischs in einem Vakuum oder einem Inertgas auf eine Temperatur von 550-800°C zum Bilden eines porösen Körpers.

2. Verfahren zur Herstellung eines thermoelektrischen Materials nach Anspruch 1, wobei das Verfahren ferner einen Prozess des Imprägnierens eines flüssigen Silikonharzes oder Glases auf den durch den Erhitzungsprozess gebildeten porösen Körper beinhaltet, um den porösen Körper zu verfestigen.

3. Verfahren zur Herstellung eines thermoelektrischen Konverters (100), konfiguriert durch elektrisches In-Reihe-Schalten eines aus einem thermoelektrischen Material des p-Typs geformten Körpers (10), der als Hauptbestandteil eine Magnesium-Silicium-Zinn-Legierung enthält und einen porösen Körper mit Poren umfasst, und eines aus thermoelektrischem Material des n-Typs geformten Körpers (20), der als Hauptbestandteil eine Magnesium-Silicium-Zinn-Legierung enthält und einen porösen Körper mit Poren umfasst, wobei das genannte Verfahren das Bereiten der genannten thermoelektrischen Materialien des p-Typs und des n-Typs mit dem Verfahren nach Anspruch 1 oder Anspruch 2 beinhaltet.

**Revendications**

1. Procédé de fabrication d'un matériau thermoélectrique contenant comme constituant principal un alliage de magnésium, silicium et étain et comprenant un corps poreux pourvu de pores, **caractérisé en ce que** ledit procédé comprend :

   une opération de pulvérisation (S1) d'une matière première (1, 1A) contenant comme constituant principal un alliage de magnésium, silicium et étain ;
   une opération d'ajout d'un agent additif pulvérisé à raison de 5 à 20 % en poids afin de former des pores (2, 2A) dans la matière première pulvérisée dans l'opération de pulvérisation, ledit agent additif pulvérisé ajouté étant mélangé avec la matière première pulvérisée et dispersé, dans lequel l'agent additif pulvérisé est de l'alcool polyvinylique (3) ;

une opération de moulage d'un mélange obtenu par l'opération d'ajout ; et

une opération de chauffage (55) du mélange moulé dans l'opération de moulage sous vide ou sous un gaz inerte à une température de 550 à 800 °C afin de former un corps poreux.

2. Procédé de fabrication d'un matériau thermoélectrique selon la revendication 1, dans lequel le procédé comprend en outre une opération d'imprégnation d'une résine silicone ou de verre liquide dans le corps poreux formé par l'opération de chauffage afin de solidifier le corps poreux.

3. Procédé de fabrication d'un convertisseur thermoélectrique (100) configuré en reliant électriquement en série un corps moulé (10) en matériau thermoélectrique de type p contenant comme constituant principal un alliage de magnésium, silicium et étain et comprenant un corps poreux pourvu de pores, et un corps moulé (20) en matériau thermoélectrique de type n contenant comme constituant principal un alliage de magnésium, silicium et étain et comprenant un corps poreux pourvu de pores, dans lequel ledit procédé comprend la préparation desdits matériaux thermoélectriques de type p et de type n selon le procédé de la revendication 1 ou de la revendication 2.

# FIG.1

# FIG.2

# FIG.3

```
        ┌─────────┐
        │  START  │
        └─────────┘
             │
             ▼                    ⌒S1
   ┌───────────────────────────┐
   │    POWDERING PROCESS      │
   └───────────────────────────┘
             │
             ▼                    ⌒S2
   ┌───────────────────────────┐
   │    SLURRYING PROCESS      │
   └───────────────────────────┘
             │
             ▼                    ⌒S3
   ┌───────────────────────────┐
   │     GELLING PROCESS       │
   └───────────────────────────┘
             │
             ▼                    ⌒S4
   ┌───────────────────────────┐
   │     DRYING PROCESS        │
   └───────────────────────────┘
             │
             ▼                    ⌒S5
   ┌───────────────────────────┐
   │     HEATING PROCESS       │
   └───────────────────────────┘
             │
             ▼
        ┌─────────┐
        │   END   │
        └─────────┘
```

# FIG.4

# FIG.5

# FIG.6

# FIG.7

# FIG.8

START

S11

POWDERING PROCESS

S12

ADDING PROCESS OF
KALIUM CHLORIDE

S13

REMOVING PROCESS OF
KALIUM CHLORIDE

S14

HEATING PROCESS

END

# FIG.9

# FIG.10

```
                    ┌──────────┐
                    │  START   │
                    └──────────┘
                         │
   ┌─────────────────────┤
   │                     ▼                    ┌─S21
   │              ┌────────────────────┐
   │              │ POWDERING PROCESS  │
   │              └────────────────────┘
   │                     │
   │                     ▼                    ┌─S22
REPEATING         ┌────────────────────┐
ONCE OR TWICE     │  MOLDING PROCESS   │
   │              └────────────────────┘
   │                     │
   │                     ▼                    ┌─S23
   │              ┌────────────────────┐
   │              │  HEATING PROCESS   │
   │              └────────────────────┘
   └─────────────────────┤
                         ▼                    ┌─S24
              ┌────────────────────────┐
              │ RE-POWDERING PROCESS   │
              └────────────────────────┘
                         │
                         ▼                    ┌─S25
              ┌────────────────────────┐
              │   ADDING PROCESS OF    │
              │      PVA POWDER        │
              └────────────────────────┘
                         │
                         ▼                    ┌─S26
              ┌────────────────────────┐
              │    MOLDING PROCESS     │
              └────────────────────────┘
                         │
                         ▼                    ┌─S27
              ┌────────────────────────┐
              │    HEATING PROCESS     │
              └────────────────────────┘
                         │
                         ▼
                    ┌──────────┐
                    │   END    │
                    └──────────┘
```

FIG.11A

FIG.11B

3      1

2B      1B

HEAT
TREATMENT

# FIG.12

# FIG.13

# FIG.14

# FIG.15

# FIG.16

# FIG.17

# FIG.18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014192468 A
- EP 2447233 A1
- JP 5079559 B


**Non-patent literature cited in the description**

- **KINICHI UEMURA ; ISAO NISHIDA.** Thermoelectric Semiconductor And The Application. Nikkan Kogyo Newspaper Company, 1988
- **KAKUEI MATSUBARA.** About Thermoelectric Conversion. *J.Plasma Fusion Res.No.12,* 2011, 818-824
- Thermoelectric Conversion Basics And Application. Shoukabou. 2005
- **WEI LIU et al.** Convergence Of Conduction Bands As A Means Of Enhancing Thermoelectric Performance Of n-Type Mg2Si1-xSnx Solid Solutions. *Physical Review Letters,* 2012, vol. 108, 166601